# EUROPEAN PATENT SPECIFICATION

(11) **EP 3 220 135 B1**
(45) Date of publication and mention of the grant of the patent: **28.08.2019**
(21) Application number: 17161487.8
(22) Date of filing: 17.03.2017
(51) Int. Cl.: G01N 23/2252, H01J 37/244, G01N 23/223, H01L 39/10

(54) **X-RAY ANALYZER**
RÖNTGENANALYSATOR
ANALYSEUR DE RAYONS X

(30) Priority: 17.03.2016 JP 2016053741
(43) Date of publication of application: 20.09.2017
(73) Proprietor: Hitachi High-Tech Science Corporation, Tokyo 105-0003 (JP)
(72) Inventor: TANAKA, Keiichi, Tokyo, 105-0003 (JP); NAGATA, Atsushi, Tokyo, 105-0003 (JP); NAKAYAMA, Satoshi, Tokyo, 105-0003 (JP); CHINONE, Kazuo, Tokyo, 105-0003 (JP)
(74) Representative: Miller Sturt Kenyon

(56) References cited:
- US-A1- 2005 184 238
- US-A1- 2015 177 167
- US-B1- 6 233 307

## Description

### TECHNICAL FIELD

The present disclosure relates to an X-ray analyzer.

### BACKGROUND

Recently, a superconductor X-ray detector is attracted as an X-ray analyzer which can recognize energy of an X-ray. A detector among the superconductor X-ray detector, which has a superconductor transition edge sensor (referred to as "a TES" below) is a calorimeter having high sensitivity and uses rapid resistance change (for example, when the temperature change is several mK, resistance change is 0.1 Ω) when superconduction-normal conduction transition of a thin metal film is performed. The TES is also referred to as a microcalorimeter.

The TES analyzes a sample in a manner that the TES detects the temperature change in the TES, which is caused when a fluorescent X-ray or a characteristic X-ray is incident. The fluorescent X-ray or a characteristic X-ray is generated from the sample which is an analysis target, by irradiation with a radial ray such as a primary X-ray or a primary electron beam. The TES has energy resolution higher than that of other detectors. For example, the TES can obtain energy resolution of 10 eV or less, in a characteristic X-ray of 5.9 keV. In a case where the TES is attached to a scanning electron microscope or a transmission electron microscope, the TES acquires a characteristic X-ray generated from a sample which has been irradiated with an electron beam. Thus, for example, it is possible to easily separate a peak in an energy spectrum of the characteristic X-ray (for example, Si-Kα, W-Mα, W-Mβ, and the like). Separating the peak in an energy spectrum of the characteristic X-ray is not possible in the semiconductor type X-ray detector.

Since the TES is a highly-sensitive calorimeter, in order to perform a stable operation, providing a heat shield as measures against radiation is required, and excluding a gas functioning as a thermal conductor from a high-temperature portion and a low-temperature portion as measures against thermal conduction is required. An X-ray generated from a sample is required to be introduced into the TES, and thus an X-ray window is mounted on the heat shield. Further, a room-temperature shield is disposed around the heat shield. The room-temperature shield is used for blocking the heat shield as measures against thermal conduction, from an outdoor atmosphere and disposing the heat shield under high vacuum. An X-ray window (X-ray transmission portion) having vacuum resistance is mounted on the room-temperature shield (for example, see JP-A-2015-121479).

US 6233307 discloses a compact X-ray spectrometer in which an X-ray tube projects into the sample chamber. A detector is in a detector chamber, which is separated from the sample chamber in a vacuum tight manner. The sample chamber includes a wall element which opens to allow direct access to the sample, and closes to seal the sample chamber.

### SUMMARY

The present disclosure provides an X-ray analyzer in which versatility and improvement of X-ray acquisition efficiency can be achieved together.

According to the present disclosure, there is provided an X-ray analyzer according to independent claim 1, comprising: an X-ray excitation device comprising a sample chamber in which a sample as an analysis target is allowed to be disposed; an X-ray detection device comprising: an X-ray detector configured to detect a characteristic X-ray emitted from the sample; and a room-temperature shield surrounding the X-ray detector; and a gate valve disposed between the X-ray excitation device and the X-ray detection device, wherein an inside of the room-temperature shield is communicatable with an inside of the sample chamber, wherein the gate valve comprises a partition plate configured to block communication between the inside of the sample chamber and the inside of the room-temperature shield, and wherein the partition plate has an X-ray transmission portion allowing the characteristic X-ray emitted from the sample to pass therethrough. The gate valve is openable and closable, and at least a portion of the room-temperature shield is formed by a bellows.

According to the present disclosure, a gate valve includes a partition plate provided to enable blocking of communication between an inside of the sample chamber and an inside of the room-temperature shield. Since the partition plate has an X-ray transmission portion, it is possible to obtain a characteristic X-ray emitted from a sample disposed in the sample chamber, in an X-ray detection unit regardless of whether or not the inside of the sample chamber and the inside of the room-temperature shield communicate with each other. Thus, the gate valve is closed, and thus it is possible to perform analysis in a state where the inside of the sample chamber is under low vacuum, while the inside of the room-temperature shield is maintained to be a state of high vacuum. The gate valve is opened, and thus it is possible to perform analysis in a state where the inside of the room-temperature shield and the inside of the sample chamber are under high vacuum. Thus, analysis in a high-vacuum state and a low vacuum state is possible, and versatility is improved. In addition, when analysis in the high-vacuum state is performed, a characteristic X-ray emitted from a sample can be detected in the X-ray detection unit without being transmitted through the X-ray transmission portion of the partition plate. Thus, it is possible to suppress attenuation of a characteristic X-ray and to improve X-ray acquisition efficiency in comparison to analysis in a state where the gate valve is closed. Accordingly, an X-ray analyzer in which versatility and improvement of X-ray acquisition efficiency is possible together can be provided. In addition, since the room-temperature shield can be deformed, it is possible to easily adjust the position of the X-ray detection unit for an X-ray excitation device, in the configuration in which the room-temperature shield is fixed to the gate valve. Thus, it is possible to obtain an X-ray analyzer which is very convenient for use.

The X-ray transmission portion may be formed by an aluminum film laminated on an organic film or a silicon nitride film.

According to the present disclosure, it is possible to suppress reduction of acquisition efficiency of a characteristic X-ray of 1 keV or lower, and to perform efficient heat shielding for the X-ray detection unit. According to a silicon nitride film, since oxygen or carbon is not contained in the film, it is possible to appropriately analyze each of oxygen and carbon.

According to the present disclosure, since the room-temperature shield can be deformed, it is possible to easily adjust the position of the X-ray detection unit for an X-ray excitation device, in the configuration in which the room-temperature shield is fixed to the gate valve. Thus, it is possible to obtain an X-ray analyzer which is very convenient for use.

The X-ray analyzer may further comprise a capillary disposed in the sample chamber and configured to propagate a characteristic X-ray emitted from the sample, toward the X-ray detector.

According to the present disclosure, it is possible to condense characteristic X-rays emitted from a sample by capillary and emit the condensed characteristic X-ray toward the X-ray detection unit. In addition, the capillary is disposed in the sample chamber. Thus, it is possible to cause a characteristic X-ray emitted from the sample to be incident to the capillary with high efficiency. Accordingly, it is possible to improve X-ray acquisition efficiency.

The X-ray analyzer may further comprise a capillary adjustor provided in the X-ray excitation device and configured to adjust a position of the capillary, wherein the capillary adjustor comprises a cylindrical holder, and wherein the capillary is held by the holder through at least a pair of O-rings, which are disposed between the capillary and an inner circumferential surface of the holder while being separated from each other in an extension direction of the holder.

According to the present disclosure, an inner circumferential surface of a holder can evenly hold the capillary by an O-ring. Thus, it is possible to easily align the center axis of the holder and the center axis of the capillary to each other. Accordingly, it is possible to easily adjust the position of the capillary for the sample and the X-ray detection unit, and to obtain an X-ray analyzer which is very convenient for use.

The X-ray detection device may be attachable and detachable to and from the gate valve.

According to the present disclosure, when an incident-side focus position of the capillary for the sample is adjusted, for example, an X-ray detection device may be detached, and an X-ray detector or a fluorescent screen having a wide sensitive area may be disposed. Thus, when the incident-side focus position of the capillary matches with the sample, X-rays emitted from the capillary can be acquired with high efficiency. Accordingly, it is possible to easily adjust the position of the capillary. Thus, it is possible to obtain an X-ray analyzer which is very convenient for use.

The X-ray detection device may further comprise: a cold head, the X-ray detector being disposed at a tip end of the cold head; and a heat shield disposed inside the room-temperature shield to surround the X-ray detector and the cold head.

The heat shield may comprise an X-ray window, the X-ray window disposed between the X-ray transmission portion and the X-ray detector for allowing the characteristic X-ray emitted from the sample and passed through the X-ray transmission portion to reach the X-ray detector.

The X-ray detection device may further comprise a snout attached to a body of the X-ray detection device, the snout comprising the cold head, the room-temperature shield and the heat shield.

According to the present disclosure, a gate valve includes a partition plate provided to enable blocking of communication between an inside of the sample chamber and an inside of the room-temperature. Since the partition plate has an X-ray transmission portion, it is possible to obtain a characteristic X-ray emitted from a sample disposed in the sample chamber, in an X-ray detection unit regardless of whether or not the inside of the sample chamber and the inside of the room-temperature shield communicate with each other. Thus, the gate valve is closed, and thus it is possible to perform analysis in a state where the inside of the sample chamber is under low vacuum, while the inside of the room-temperature shield is maintained to be a state of high vacuum. The gate valve is opened, and thus it is possible to perform analysis in a state where the inside of the room-temperature shield and the inside of the sample chamber are under high vacuum. Thus, analysis in a high-vacuum state and a low vacuum state is possible, and versatility is improved. In addition, when analysis in the high-vacuum state is performed, a characteristic X-ray emitted from a sample can be detected in the X-ray detection unit without being transmitted through the X-ray transmission portion of the partition plate. Thus, it is possible to suppress attenuation of a characteristic X-ray and to improve X-ray acquisition efficiency in comparison to analysis in a state where the gate valve is closed. Accordingly, an X-ray analyzer in which versatility and improvement of X-ray acquisition efficiency is possible together can be provided.

### BRIEF DESCRIPTION OF THE DRAWINGS

Embodiments of the invention will now be described by way of example only with reference to the accompanying drawings, wherein like numbers reference like elements.
Fig. 1 is a partially-sectional view schematically illustrating a configuration of an X-ray analyzer according to an illustrative embodiment;
Fig. 2 is a partially-sectional view schematically illustrating a configuration of an X-ray analyzer according to a modification example of the illustrative embodiment;
Fig. 3 is a partially-sectional view illustrating a capillary and a holder; and
Fig. 4 is a diagram illustrating a method of adjusting a position of the capillary, and is a partially-sectional view schematically illustrating a configuration portion of the X-ray analyzer according to the modification example of the illustrative embodiment.

### DETAILED DESCRIPTION

As the X-ray analyzer, there is an analytical electron microscope in which an electron microscope and an X-ray detector are combined. In the analytical electron microscope, a sample is irradiated with an electron beam, and an element at an electron-beam irradiation portion is specified by using a characteristic X-ray which is generated from an irradiation point. The electron microscope is used generally in a state of having an inside in a high vacuum state. However, in a case where a sample is non-conductive, in order to suppress an occurrence of charge-up of the sample, a gas such as nitrogen may be introduced into the inside thereof, and thus low vacuum state may occur.

An X-ray emitted from a sample of an analysis target is transmitted through the X-ray transmission portions mounted on the room-temperature shield and the heat shield, and is incident to a detector. Thus, in order to obtain, specifically, a characteristic X-ray of 1 keV or lower with high efficiency, it is necessary that, for example, the number of X-ray transmission portions is reduced so as to improve transmittance of X-rays.

Here, in a case where the sample is disposed under high vacuum, even though the room-temperature shield is not provided between the sample and the heat shield, it is possible to dispose the heat shield under high vacuum. Thus, as a method using the X-ray analyzer, providing the room-temperature shield between the sample and the heat shield is not required if disposition of the sample is limited to being under high vacuum. As a result, it is possible to improve transmittance of an X-ray as much as the X-ray transmission portion mounted on the room-temperature shield being omitted.

However, in a case where the sample is disposed under low vacuum, if the room-temperature shield is provided so as to perform measures against thermal conduction for the heat shield, the gas causes heat to be conducted to the detector through the heat shield, and thus an operation becomes unstable. Thus, in a case where the sample may be disposed under low vacuum, it is desirable that the room-temperature shield is provided around the heat shield as the method using the X-ray analyzer.

Accordingly, there may require improvement in a point in that versatility in which analysis is possible in a high-vacuum state and a low vacuum state, and improvement of acquisition efficiency of an X-ray is achieved together. Thus, the present disclosure provides an X-ray analyzer in which versatility and improvement of X-ray acquisition efficiency can be achieved together.

Hereinafter, an X-ray analyzer according to an illustrative embodiment of the present disclosure will be described with the accompanying drawings.

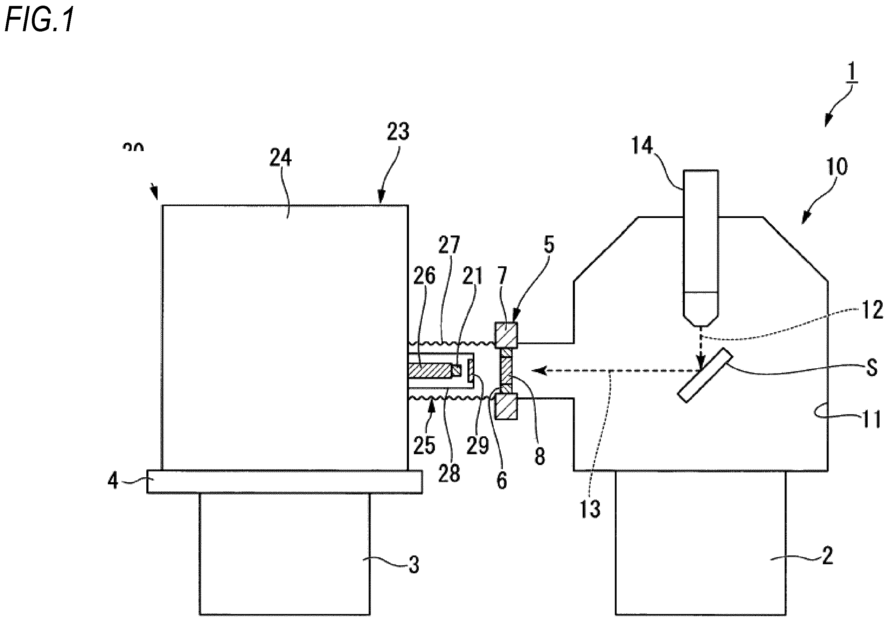

Fig. 1 is a partially-sectional view schematically illustrating a configuration of an X-ray analyzer according to an illustrative embodiment.

As illustrated in Fig. 1, an X-ray analyzer 1 in the illustrative embodiment includes an X-ray excitation device 10, an X-ray detection device 20, and a gate valve 5 disposed between the X-ray excitation device 10 and the X-ray detection device 20.

The X-ray excitation device 10 is an electron microscope, for example. The X-ray excitation device 10 includes a sample chamber 11 and an electron gun 14. A sample S as an analysis target can be disposed in the sample chamber 11. The electron gun 14 irradiates the sample S with an electron beam 12, so as to excite the sample S, and emits a characteristic X-ray 13 from the sample S. The gate valve 5 is attached to the sample chamber 11, so as to be attachable and detachable. A vacuum pump (not illustrated) is connected to the sample chamber 11, and can evacuate the gas in the sample chamber 11. Further, the sample chamber 11 can introduce a gas such as nitrogen. The X-ray excitation device 10 is placed on a first trestle 2 installed on the bottom surface.

The X-ray detection device 20 includes a superconductive transition edge sensor (TES) (X-ray detection unit) 21 and a refrigeration machine 23.

The TES 21 can detect a characteristic X-ray 13 emitted from the sample S. The TES 21 uses superconductive transition by a superconductor. The TES 21 holds an operation point in an intermediate state between normal conductivity and superconductivity, in a detection operation of an X-ray. Thus, in a case where one piece of an X-ray is absorbed by the TES 21, in a state where an operation point is held in the middle of superconductive transition, for example, a resistance change of several µW corresponding to a temperature change of 100 mK can be obtained, and a radiation pulse in an order of µA can be obtained. Data obtained by obtaining a relationship between a pulse peak value and energy of a radial ray in advance is stored, and thus it is possible to detect energy of an incident radial ray from the peak value of a signal pulse even though the TES 21 is irradiated with the radial ray having unknown energy.

The refrigeration machine 23 cools the TES 21. The refrigeration machine 23 includes a refrigeration machine main body 24 and a snout 25 attached to the refrigeration machine main body 24.

The refrigeration machine main body 24 is, for example, a dilution refrigeration machine or an insulated demagnetized refrigeration machine. The dilution refrigeration machine performs cooling by using an enthalpy difference when 3He is dissolved from a dense phase to a dilute phase in a mixing chamber. The insulated demagnetized refrigeration machine cools an object connected to the magnetic medium in a manner that a magnetic field is applied to a magnetic medium and thus a direction of a spin is aligned, and entropy when the magnetic field is removed is increased. The refrigeration machine main body 24 is supported by a refrigerator position adjusting mechanism 4, and thus can have an adjusted position. The refrigeration-machine position adjusting mechanism 4 is placed on a second trestle 3 installed on the bottom surface.

The snout 25 includes a cold head 26, a room-temperature shield 27, and a heat shield 28.

The cold head 26 is connected to a location which is cooled most in the refrigeration machine main body 24. The TES 21 is installed at the tip end of the cold head 26. The cold head 26 is cooled to the vicinity of 100 mK by the refrigeration machine main body 24.

The room-temperature shield 27 is disposed to surround the TES 21 and the cold head 26. The room-temperature shield 27 is formed by a deformable bellows, for example. The tip end of the room-temperature shield 27 is attached to be attachable and detachable to and from the gate valve 5. Thus, the inside of the room-temperature shield 27 can communicate with the inside of the sample chamber 11. The room-temperature shield 27 is attached to be attachable and detachable to and from the gate valve 5, and thus the entirety of the X-ray detection device 20 is attached to be attachable and detachable to and from the gate valve 5. The gas in the room-temperature shield 27 can be evacuated by a vacuum pump (not illustrated). The inside of the room-temperature shield 27 normally has a vacuum degree of about 10⁻³ to 10⁻⁵ Pa (this state is referred to as a high-vacuum state below). The temperature of the room-temperature shield 27 is, for example, room temperature.

The heat shield 28 is disposed between (a) the TES 21 and the cold head 26 and (b) the room-temperature shield 27. In other words, the heat shield 28 is disposed inside the room-temperature shield 27 to surround the TES 21 and the cold head 26. The heat shield 28 shields the TES 21 and the cold head 26 against heat radiation from the room-temperature shield 27. The heat shield 28 has an X-ray window 29 for causing the characteristic X-ray 13 emitted from the sample S to reach the TES 21. The X-ray window 29 is formed by a material of a light element, in order to cause an X-ray having low energy of, specifically, 1 keV or lower to be transmitted with high efficiency. The X-ray window 29 is formed to have a thickness which is as thin as the minimum at which desired heat shield is ensured. The X-ray window 29 is formed by, for example, a laminated medium in which an aluminum film is laminated on an organic film or a silicon nitride film. In particle, the film thickness of the organic film or the silicon nitride film and the film thickness of the aluminum film are set to be equal to or less than 100 nm together, in order to ensure desired transmittance for an X-ray of 1 keV or lower.

The gate valve 5 includes a partition plate 6, a case 7, and a driving unit (not illustrated). The partition plate 6 is provided to enable blocking of a communication between the inside of the sample chamber 11 and the inside of the room-temperature shield 27. The case 7 holds the partition plate 6. The driving unit operates the partition plate 6. The partition plate 6 has a pressure-resistant X-ray window (X-ray transmission portion) 8 for enabling the TES 21 to acquire a characteristic X-ray emitted from the sample S in a state where the communication between the inside of the sample chamber 11 and the inside of the room-temperature shield 27 is blocked. The pressure-resistant X-ray window 8 is formed by, for example, a laminated medium in which an aluminum film is laminated on an organic film or a silicon nitride film. The pressure-resistant X-ray window 8 has pressure resistance. Even in a state where pressure in the sample chamber 11 is higher than pressure in the room-temperature shield 27, flowing of a gas in the sample chamber 11 into the room-temperature shield 27 is prevented.

An operation of the X-ray analyzer 1 in the illustrative embodiment will be described below.

The X-ray analyzer 1 can perform analysis in a low vacuum state and perform analysis in a high-vacuum state.

The analysis in a low vacuum state is performed, for example, in a case where the sample S is nonconductive like a biological sample. Regarding the analysis in a low vacuum state, while the gate valve 5 is closed and the inside of the room-temperature shield 27 is set to be in a high-vacuum state, the inside of the sample chamber 11 is set to be in a low vacuum state having a vacuum degree lower than that of the room-temperature shield 27, by using a gas such as nitrogen. In this state, if the sample S is irradiated with an electron beam 12, a characteristic X-ray 13 can be emitted from the sample S while the occurrence of charge-up of the sample S is suppressed. The characteristic X-ray 13 emitted from the sample S is transmitted through the pressure-resistant X-ray window 8 included in the partition plate 6 of the gate valve 5, and the X-ray window 29 included in the heat shield 28, and is incident to the TES 21. Thus, the sample S which is nonconductive can be analyzed. In a case of the analysis in a low vacuum state, attenuation of an X-ray of 1 keV or lower, which occurs by transmitting the characteristic X-ray 13 through the pressure-resistant X-ray window 8 is not a particular problem because, specifically, the X-ray of 1 keV or lower in the characteristic X-ray 13 emitted from the sample S is absorbed by the gas.

The analysis in a high-vacuum state is performed in a case where the charge-up of the sample S can be ignored, for example, in a case where the sample S is conductive. Regarding the analysis in a high-vacuum state, the gate valve 5 is opened, and thus the inside of the room-temperature shield 27 and the inside of the sample chamber 11 are in a high-vacuum state. In this state, if the sample S is irradiated with an electron beam 12, a characteristic X-ray 13 emitted from the sample S is transmitted through the X-ray window 29 included in the heat shield 28, and is incident to the TES 21. That is, the characteristic X-ray 13 does not pass through the pressure-resistant X-ray window 8 included in the partition plate 6 of the gate valve 5, in comparison to the analysis in a low vacuum state. Thus, it is possible to suppress attenuation of the characteristic X-ray 13 until the characteristic X-ray 13 is incident to the TES 21, in comparison to the analysis in a low vacuum state. Accordingly, it is possible to improve acquisition efficiency of an X-ray in the TES 21, and to analyze the conductive sample S at a higher energy resolution.

As described above, in the illustrative embodiment, a configuration in which the gate valve 5 includes the partition plate 6 provided to enable blocking of a communication between the inside of the sample chamber 11 and the inside of the room-temperature shield 27, and the partition plate 6 has the pressure-resistant X-ray window 8 is provided.

According to the configuration, it is possible to acquire the characteristic X-ray 13 emitted from the sample S disposed in the sample chamber 11, in the TES 21 regardless of whether or not the inside of the sample chamber 11 and the inside of the room-temperature shield 27 communicate with each other. Thus, the gate valve 5 is closed, and thus it is possible to analyze the inside of the sample chamber 11 in a low vacuum state while the inside of the room-temperature shield 27 is maintained to be in a high-vacuum state. The gate valve 5 is opened, and thus it is possible to analyze the inside of the room-temperature shield 27 and the inside of the sample chamber 11 in a high-vacuum state. Thus, analysis in a high-vacuum state and a low vacuum state is possible, and versatility is improved. In addition, when the analysis in a high-vacuum state is performed, the characteristic X-ray 13 emitted from the sample S can be detected by the TES 21 without being transmitted through the pressure-resistant X-ray window 8 of the partition plate 6. Thus, it is possible to suppress attenuation of a characteristic X-ray 13 and to improve X-ray acquisition efficiency of, specifically, a characteristic X-ray of 1 keV or lower, in a comparison to the analysis in a state where the gate valve 5 is closed. Accordingly, it is possible to provide the X-ray analyzer 1 which can achieve the versatility and improvement of the X-ray acquisition efficiency together.

The pressure-resistant X-ray window 8 is formed by a laminated medium of any of an organic film and a silicon nitride film, and an aluminum film. Thus, it is possible to effectively perform heat shield for the TES 21 while reduction of the acquisition efficiency of the characteristic X-ray 13 of 1 keV or lower is suppressed. According to a silicon nitride film, since oxygen or carbon is not contained in the film, it is possible to appropriately analyze each of oxygen and carbon.

The gate valve 5 is attachable and detachable to and from the X-ray excitation device 10 and the X-ray detection device 20. Thus, for example, when this apparatus is used only in the analysis in a high-vacuum state, the gate valve 5 is not required. Accordingly, a form in which the gate valve 5 is detached, and the X-ray excitation device 10 and the X-ray detection device 20 are directly joined to each other may be used. For example, when this apparatus is used only in the analysis in a low vacuum state, a partition wall member may be disposed instead of the gate valve 5. The partition wall member includes the pressure-resistant X-ray window 8 and blocks a communication between the inside of the sample chamber 11 and the inside of the room-temperature shield 27. Accordingly, it is possible to provide the X-ray analyzer 1 in which the configuration is flexibly changed in accordance with the purpose of a use. In a case using the partition wall member, when the X-ray detection device 20 is detached from the X-ray excitation device 10, a state where the partition wall member is attached to the X-ray excitation device 10 desirably occurs. Thus, since the inside of the sample chamber 11 is held to be in a vacuum state, it is possible to reduce a load of the vacuum pump connected to the sample chamber 11, and to suppress an occurrence of failure.

Next, a modification example of the above-described illustrative embodiment will be described.

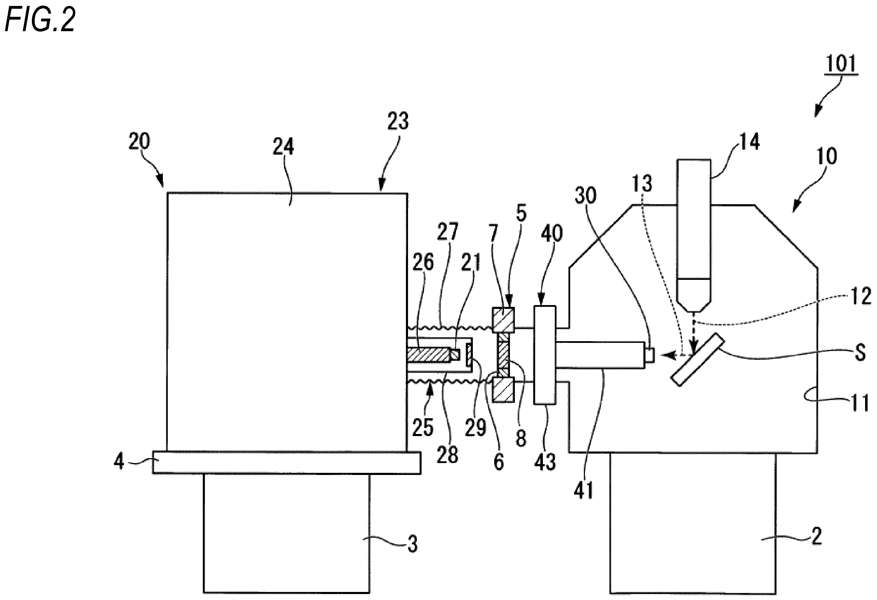

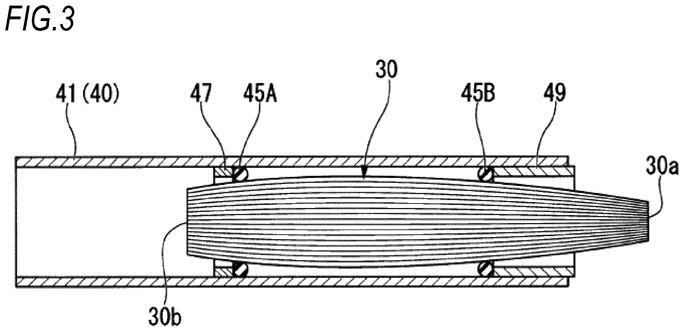

Fig. 2 is a partially-sectional view schematically illustrating a configuration of an X-ray analyzer according to a modification example of the illustrative embodiment. Fig. 3 is a partially-sectional view illustrating the capillary and the holder.

The modification example of the illustrative embodiment illustrated in Fig. 2 is different from the illustrative embodiment illustrated in Fig. 1 in that a capillary 30 is provided. Similar components to those in the illustrative embodiment illustrated in Fig. 1 are denoted by the same reference signs, and detailed descriptions thereof will be omitted.

As illustrated in Fig. 2, an X-ray analyzer 101 in the modification example includes the capillary 30 and capillary adjusting means 40.

As illustrated in Figs. 2 and 3, the capillary 30 propagates a characteristic X-ray 13 emitted from a sample S, toward the TES 21. The capillary 30 is formed by bundling thin glass tubes, for example. The capillary 30 is extended in a direction (referred to as "a propagation direction" below) from the sample S toward the TES 21. In the capillary 30, a sectional shape orthogonal to the propagation direction is circular, both end portions have a diameter smaller than that of the center portion, and an end portion 30a on the sample S side has a diameter smaller than that of an end portion 30b on the TES 21 side.

The capillary adjusting means 40 is used for adjusting the position of the capillary 30. The capillary adjusting means 40 includes a holder 41 and a stage 43. The holder 41 has a columnar shape and holds the capillary 30. The stage 43 supports the holder 41 in a state where the position is adjustable.

As illustrated in Fig. 3, the holder 41 is extended in the propagation direction. An inner diameter of the holder 41 is larger than the largest diameter of the capillary 30. The capillary 30 is disposed on an inner side of the holder 41, in a state of causing the end portion 30a on the sample S side to protrude from the holder 41. The capillary 30 is held by the holder 41 through a pair of O-rings 45A and 45B which are disposed between the capillary 30 and the inner circumferential surface of the holder 41. The pair of O-rings 45A and 45B are disposed to be separated from each other in the propagation direction, and to be positioned on both sides in the propagation direction in a state where a portion at which the outermost diameter of the capillary 30 is large is interposed between the O-rings 45A and 45B. An inner flange portion 47 which protrudes toward an inner side in a diameter direction thereof is provided on the inner circumferential surface of the holder 41. The inner flange portion 47 abuts against the O-ring 45A on the TES 21 from the TES 21 side in the propagation direction, in a state of being separated from the capillary 30 at a gap. A columnar fixation screw 49 is spirally inserted into the end portion of the holder 41 on the sample S side. The fixation screw 49 abuts against the O-ring 45B on the sample S side from the sample S side in the propagation direction.

As described above, the O-ring 45B on the sample S side is disposed on the sample S side of the portion of the capillary 30 at which the outermost diameter is large. Thus, the fixation screw 49 is spirally inserted into the holder 41, and thus the O-ring 45B on the sample S side is pressed toward the TES 21 side, and may be widened toward an outside thereof in the diameter direction.

Accordingly, the capillary 30 is pressed toward the TES 21 side, and is evenly pressed toward the inside thereof in the diameter direction, from the inner circumferential surface of the holder 41.

As described above, the O-ring 45A on the TES 21 side is disposed on the TES 21 side of the portion of the capillary 30 at which the outermost diameter is large. The inner flange portion 47 abuts from the TES 21 side. Thus, the capillary 30 is pressed toward the TES 21 side, and thus the O-ring 45A on the TES 21 side receives a reaction force from the inner flange portion 47 toward the sample S side, and may be widened toward the outside thereof in the diameter direction. Accordingly, the capillary 30 is pressed toward the sample S side, and is evenly pressed from the inner circumferential surface of the holder 41 toward the inside thereof in the diameter direction.

In this manner, the capillary 30 is evenly pressed from the inner circumferential surface of the holder 41 toward the inside thereof in the diameter direction, on both of the sides thereof in the propagation direction by the pair of the O-rings 45A and 45B. Thus, axis alignment is mechanically performed to cause the center axis of the capillary 30 to match with the center axis of the holder 41.

As illustrated in Fig. 2, the stage 43 supports the end portion of the holder 41 on the TES 21 side. The stage 43 has a configuration in which the holder 41 is movable in a certain direction orthogonal to the propagation direction by a pair of micrometers (not illustrated), for example.

A method of adjusting the positions of the capillary 30 and the TES 21 will be described below.

Firstly, the position of the capillary 30 is adjusted. When the position of the capillary 30 is adjusted, the incident-side focus position of the capillary 30 is caused to match with the position of the sample S. The position of the capillary 30 is adjusted in a state where the gate valve 5 is closed, and the sample S is irradiated with an electron beam 12 so as to emit a characteristic X-ray 13 from the sample S. In the adjustment of the position of the capillary 30, when the incident-side focus position of the capillary 30 and the position of the sample S match with each other, a characteristic X-ray 13 which propagates through the capillary 30 and is emitted is detected, and thus it is possible to confirm matching between the incident-side focus position of the capillary 30 and the position of the sample S. At this time, the characteristic X-ray 13 emitted from the capillary 30 passes through the pressure-resistant X-ray window 8. However, the dimension (for example, ϕ8 mm) of the pressure-resistant X-ray window 8 is sufficiently larger than the size (for example, ϕ1 mm) of a focal point on the emission side of the capillary 30. Thus, the positional relationship between the pressure-resistant X-ray window 8 and the capillary 30 can be ignored.

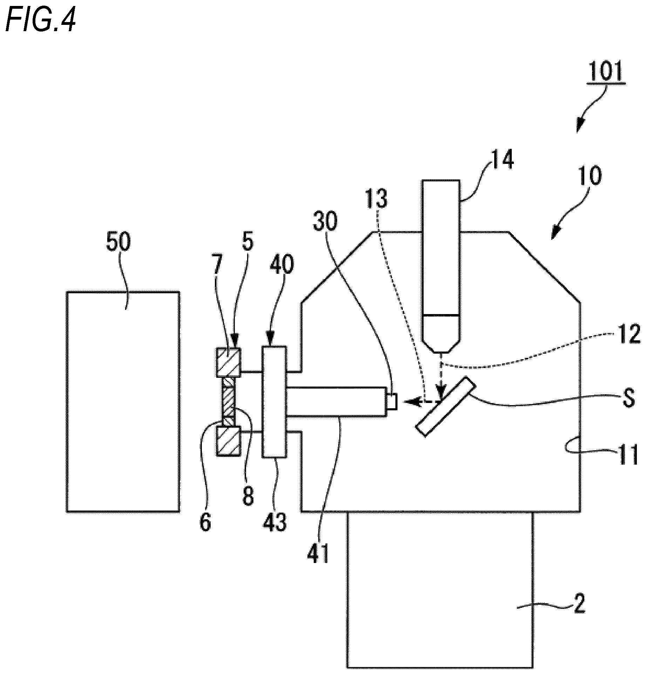

Fig. 4 is a diagram illustrating a method of adjusting a position of the capillary, and is a partially-sectional view schematically illustrating a configuration portion of the X-ray analyzer according to the modification example of the illustrative embodiment.

The characteristic X-ray 13 emitted from the capillary 30 is desirably detected by using an adjustment X-ray detector 50 which has a sensitive area wider than that of the TES 21. At this time, the X-ray detection device 20 is detached from the gate valve 5 in a state where the gate valve 5 is closed, and the adjustment X-ray detector 50 is disposed at a substantially emission-side focus position of the capillary 30 (see Fig. 4). Thus, it is possible to acquire the characteristic X-ray 13 emitted from the capillary 30 and to determine whether or not the incident-side focus position of the capillary 30 and the position of the sample S match with each other, regardless of the position of the capillary 30. A fluorescent screen may be used instead of the adjustment X-ray detector 50.

In a case where the adjustment X-ray detector 50 is vacuum correspondence as the modification, the gate valve 5 may turn OFF, and may be connected with the sample chamber 11 which is in a vacuum state, in a vacuum.

Then, the position of the TES 21 is adjusted. The position of the TES 21 is adjusted in a state where the incident-side focus position of the capillary 30 and the position of the sample S match with each other. In the adjustment of the position of the TES 21, the X-ray detection device 20 is attached to the gate valve 5, and the position of the TES 21 is moved along with the refrigeration machine main body 24 while the room-temperature shield 27 is deformed by the refrigeration-machine position adjusting mechanism 4. If the position of the TES 21 matches the emission-side focus position of the capillary 30, the TES 21 detects an X-ray. Thus, it is possible to determine whether or not the emission-side focus position of the capillary 30 matches with the position of the TES 21.

With the above descriptions, position adjustment of the capillary 30 and the TES 21 is completed.

As described above, in the modification example, the capillary 30 which propagates the characteristic X-ray 13 emitted from the sample S, toward the TES 21 is provided. Thus, it is possible to condense the characteristic X-ray 13 and to emit the characteristic X-ray 13 toward the TES 21, by the capillary 30. In addition, the capillary 30 is disposed in the sample chamber 11. Thus, it is possible to cause the characteristic X-ray 13 emitted from the sample S to be incident to the capillary 30 with high efficiency. Accordingly, it is possible to improve X-ray acquisition efficiency of the X-ray analyzer 101.

The capillary 30 is held by the holder 41 through a pair of O-rings 45A and 45B which are disposed to be separated from each other between the capillary 30 and the inner circumferential surface of the holder 41 in the propagation direction. Thus, the inner circumferential surface of the holder 41 can evenly hold the capillary 30 by the O-rings 45A and 45B. Thus, it is possible to easily align the center axis of the holder 41 and the center axis of the capillary 30 to each other. Accordingly, it is possible to easily adjust the position of the capillary 30 for the sample S and the TES 21, and to obtain the X-ray analyzer 101 which is very convenient for use.

The X-ray detection device 20 is attached to the gate valve 5 so as to be detachable. Thus, when the incident-side focus position of the capillary 30 for the sample S is adjusted, the X-ray detection device 20 may be detached, and the adjustment X-ray detector 50 or a fluorescent screen which has a wide sensitive area may be disposed. Thus, it is possible to acquire an X-ray emitted from the capillary 30 with high efficiency when the incident-side focus position of the capillary 30 matches with the sample S, and thus it is possible to easily adjust the position of the capillary 30. Accordingly, it is possible to obtain the X-ray analyzer 101 which is very convenient for use.

The room-temperature shield 27 is formed by a bellows, and thus it is possible to deform the room-temperature shield 27. Thus, in the configuration in which the room-temperature shield 27 is fixed to the gate valve 5, it is possible to easily adjust the position of the TES 21 for the X-ray excitation device 10. Accordingly, it is possible to obtain the X-ray analyzer 101 which is very convenient for use.

The position adjustment of the TES 21 in the modification example may be performed similarly in the above-described illustrative embodiment. That is, in the above-described illustrative embodiment, the room-temperature shield 27 is formed by a bellows, and thus it is possible to easily adjust the position of the TES 21 for the X-ray excitation device 10, and to obtain the X-ray analyzer 1 which is very convenient for use.

In the modification example, the capillary 30 is held by the holder 41 through the O-rings 45A and 45B. However, a fixing method between the capillary 30 and the holder is not limited thereto, and the capillary 30 and the holder may be fixed and bonded to each other by, for example, a screw.

The scope of the invention is not limited to the above-described illustrative embodiment, and includes a case in which changes are made to the above-described illustrative embodiment, without departing from the scope of the invention as defined by the claims. That is, the configuration of the above-described illustrative embodiment is just an example, and may be appropriately changed.

For example, in the illustrative embodiment, the entirety of the room-temperature shield 27 is formed by a bellows, but it is not limited thereto. If at least a portion thereof is formed by a bellows, it is possible to easily adjust the position of the TES 21.

In the above illustrative embodiment, the X-ray excitation device 10 and the refrigeration machine main body 24 are supported by the trestles (first trestle 2 and second trestle 3) which are separated from each other. However, it is not limited thereto, and the X-ray excitation device 10 and the refrigeration machine main body 24 may be supported by an integrated trestle.

## Claims

1. An X-ray analyzer (1) comprising:
an X-ray excitation device (10) comprising a sample chamber (11) in which a sample as an analysis target is allowed to be disposed;
an X-ray detection device (20) comprising:
an X-ray detector (21) configured to detect a characteristic X-ray emitted from the sample; and
a room-temperature shield (27) surrounding the X-ray detector (21); and
a gate valve (5) disposed between the X-ray excitation device (10) and the X-ray detection device (20),
wherein an inside of the room-temperature shield (27) is communicatable with an inside of the sample chamber (11),
wherein the gate valve (5) comprises a partition plate (6) configured to block communication between the inside of the sample chamber (11) and the inside of the room-temperature shield (27),
wherein the gate valve (5) is openable and closable, and
at least a portion of the room-temperature shield (28) is formed by a bellows,
**characterized in that** the partition plate (6) has an X-ray transmission portion (8) allowing the characteristic X-ray emitted from the sample to pass therethrough.

2. The X-ray analyzer according to claim 1, wherein the X-ray transmission portion is formed by an aluminum film laminated on an organic film or a silicon nitride film.

3. The X-ray analyzer according to claim 1 or 2, further comprising:
a capillary disposed in the sample chamber and configured to propagate a characteristic X-ray emitted from the sample, toward the X-ray detector.

4. The X-ray analyzer according to claim 3, further comprising:
a capillary adjustor provided in the X-ray excitation device and configured to adjust a position of the capillary,
wherein the capillary adjustor comprises a cylindrical holder, and
wherein the capillary is held by the holder through at least a pair of O-rings, which are disposed between the capillary and an inner circumferential surface of the holder while being separated from each other in an extension direction of the holder.

5. The X-ray analyzer according to claim 3 or 4, wherein the X-ray detection device is attachable and detachable to and from the gate valve.

6. The X-ray analyzer according to claim 1, wherein the X-ray detection device (1) further comprises:
a cold head (26), the X-ray detector (219 being disposed at a tip end of the cold head (26); and
a heat shield (28) disposed inside the room-temperature shield (27) to surround the X-ray detector (21) and the cold head (26).

7. The X-ray analyzer according to claim 6,
wherein the heat shield comprises an X-ray window, the X-ray window disposed between the X-ray transmission portion and the X-ray detector for allowing the characteristic X-ray emitted from the sample and passed through the X-ray transmission portion to reach the X-ray detector.

8. The X-ray analyzer according to claim 6 or 7, wherein the X-ray detection device further comprises:
a snout (25) attached to a body (24) of the X-ray detection device (20), the snout comprising the cold head (26), the room-temperature shield (27) and the heat shield (28).

## Patentansprüche

1. Röntgenanalysator (1), umfassend:
eine Röntgenstrahl-Anregungsvorrichtung (10), die eine Probenkammer (11) umfasst, in der eine Probe als Analyseziel angeordnet werden kann;
eine Röntgenstrahl-Erfassungsvorrichtung (20), umfassend:
einen Röntgendetektor (21), der dafür ausgelegt ist, eine charakteristische Röntgenstrahlung festzustellen, die von der Probe emittiert wird; und
eine Raumtemperaturabschirmung (27), die den Röntgendetektor (21) umgibt; und
einen Absperrschieber (5), der zwischen der Röntgenstrahlenanregungsvorrichtung (10) und der Röntgenstrahl Erfassungsvorrichtung (20) angeordnet ist,
wobei eine Innenseite der Raumtemperaturabschirmung (27) mit einer Innenseite der Probenkammer (11) kommunizieren kann,
wobei der Absperrschieber (5) eine Trennplatte (6) umfasst, die dafür ausgelegt ist, die Kommunikation zwischen der Innenseite der Probenkammer (11) und der Innenseite der Raumtemperaturabschirmung (27) zu blockieren,
wobei der Absperrschieber (5) geöffnet und geschlossen werden kann, und mindestens ein Teil der Raumtemperaturabschirmung (27) durch einen Balg gebildet wird,
**dadurch gekennzeichnet, dass**
die Trennplatte (6) einen Röntgen-Übertragungsteil (8) hat, der der charakteristischen Röntgenstrahlung, die von der Probe emittiert wird, ermöglicht durchzudringen.

2. Röntgenanalysator nach Anspruch 1, wobei der Röntgenstrahlen-Übertragungsteil durch einen Aluminiumfilm gebildet wird, der auf einen organischen Film oder einen Siliziumnitrid-Film auflaminiert ist.

3. Röntgenanalysator nach Anspruch 1 oder 2, der ferner umfasst:
eine Kapillare, die in der Probenkammer angeordnet ist und die dafür ausgelegt ist, eine charakteristische Röntgenstrahlung, die von der Probe emittiert wird, zum Röntgendetektor hin zu verbreiten.

4. Röntgenanalysator nach Anspruch 3, der ferner umfasst:
einen Kapillareneinsteller, der in der Röntgenstrahlen-Anregungsvorrichtung vorgesehen ist und der dafür ausgelegt ist, eine Position der Kapillare einzustellen,
wobei der Kapillareneinsteller einen zylindrischen Halter umfasst, und
wobei die Kapillare durch den Halter durch mindestens ein Paar von O-Ringen gehalten wird, die zwischen der Kapillare und einer inneren Umfangsfläche des Halters angeordnet sind, wobei sie voneinander in einer Erstreckungsrichtung des Halters getrennt sind.

5. Röntgenanalysator nach Anspruch 3 oder 4, wobei die Röntgenstrahl-Erfassungsvorrichtung am Absperrschieber befestigt werden kann und von demselben gelöst werden kann.

6. Röntgenanalysator nach Anspruch 1, wobei der Röntgenanalysator (1) ferner umfasst:
einen Kaltkopf (26), wobei der Röntgendetektor (21) an einer Endspitze des Kaltkopfes (26) angeordnet ist; und
einen Hitzeschild (28), der innerhalb der Raumtemperaturabschirmung (27) angeordnet ist, um den Röntgendetektor (21) und den Kaltkopf (26) zu umgeben.

7. Röntgenanalysator nach Anspruch 6,
wobei der Hitzeschild ein Röntgenfenster umfasst,
wobei das Röntgenfenster zwischen dem Röntgenstrahl-Übertragungsteil und dem Röntgendetektor angeordnet ist, um der charakteristischen Röntgenstrahlung, die von der Probe emittiert wird und durch den Röntgenstrahl-Übertragungsteil gelaufen ist, zu ermöglichen, den Röntgendetektor zu erreichen.

8. Röntgenanalysator nach Anspruch 6 oder 7, wobei die Röntgenstrahl-Erfassungsvorrichtung ferner umfasst:
einen Rüssel (25), der an einem Körper (24) der Röntgenstrahl-Erfassungsvorrichtung (20) befestigt ist, wobei der Rüssel den Kaltkopf (26), die Raumtemperaturabschirmung (27) und den Hitzeschild (28) umfasst.

## Revendications

1. Analyseur de rayons X (1) comprenant :
un dispositif d'excitation de rayons X (10) comprenant une chambre d'échantillon (11) dans laquelle un échantillon sous forme d'une cible d'analyse peut être disposé ;
un dispositif de détection de rayons X (20) comprenant :
un détecteur de rayons X (21) conçu pour détecter un rayon X caractéristique émis par l'échantillon ; et un écran anti-température ambiante (27) entourant ledit détecteur de rayons X (21) ; et
un robinet-vanne (5) disposé entre le dispositif d'excitation de rayons X (10) et le dispositif de détection de rayons X (20),
l'intérieur de l'écran anti-température ambiante (27) pouvant communiquer avec un intérieur de la chambre d'échantillon (11),
le robinet-vanne (5) comprenant une plaque de cloisonnement (6) conçue pour bloquer la communication entre l'intérieur de la chambre d'échantillon (11) et l'intérieur de l'écran anti-température ambiante (27), le robinet-vanne (5) pouvant être ouvert et fermé, et au moins une section de l'écran anti-température ambiante (27) étant formé par un soufflet,
**caractérisé en ce que**
la plaque de cloisonnement (6) comporte une section de transmission de rayons X (8) permettant aux rayons X caractéristiques émis par l'échantillon de passer à travers.

2. Analyseur de rayons X selon la revendication 1, dans lequel la section de transmission de rayons X est formée d'un film laminé sur un film organique ou un film en nitrure de silicone.

3. Analyseur de rayons X selon la revendication 1 ou 2, comprenant en outre :
un capillaire disposé dans la chambre d'échantillon et conçu pour propager un rayon caractéristique émis par l'échantillon vers le détecteur de rayons X.

4. Analyseur de rayons X selon la revendication 3, comprenant en outre :
un ajusteur de capillaire prévu dans le dispositif d'excitation de rayons X et conçu pour ajuster une position du capillaire,
l'ajusteur de capillaire comprenant un support cylindrique, et
le capillaire étant maintenu par le support par au moins une paire de joints toriques qui sont disposés entre le capillaire et une surface circonférentielle intérieure du support tout en étant séparés l'un de l'autre dans un sens d'extension du support.

5. Analyseur de rayons X selon la revendication 3 ou 4, dans lequel le dispositif de détection de rayons X peut être attaché à et détaché du robinet-vanne.

6. Analyseur de rayons X selon la revendication 1, dans lequel le dispositif de détection de rayons X (1) comprend en outre :
une tête froide (26), le détecteur de rayons X (21) étant disposé à une pointe d'extrémité de la tête froide (26) ; et
un écran anti-chaleur (28) disposé à l'intérieur de l'écran anti-température ambiante (27) pour entourer le détecteur de rayons X (21) et la tête froide (26).

7. Analyseur de rayons X selon la revendication 6,
dans lequel l'écran anti-chaleur comprend une fenêtre à rayons X, la fenêtre à rayon X étant disposée entre la section de transmission de rayons X et le détecteur de rayons X pour permettre aux rayons X caractéristiques émis par l'échantillon et passant à travers la section de transmission de rayons d'atteindre le détecteur de rayons X.

8. Analyseur de rayons X selon la revendication 6 ou 7, dans lequel le dispositif de détection de rayons X comprend en outre :
un museau (25) fixé à un corps (24) du dispositif de rayons X (20), le museau comprenant la tête froide (26), l'écran anti-température ambiante (27) et l'écran anti-chaleur (28).
